# FASCICULE DE BREVET EUROPEEN

(11) **EP 3 048 447 B1**
(45) Date de publication et mention de la délivrance du brevet: **28.06.2017**
(21) Numéro de dépôt: 16152069.7
(22) Date de dépôt: 20.01.2016
(51) Int. Cl.: G01R 15/18, G01R 15/14, G01R 1/04, H01F 27/28

(54) **DÉTECTEUR POUR UN CONDUCTEUR D'UN RÉSEAU ÉLECTRIQUE**
DETEKTOR FÜR EINEN LEITER EINES ELEKTRISCHEN NETZES
SENSOR FOR A WIRE OF AN ELECTRIC NETWORK

(30) Priorité: 20.01.2015 FR 1550427
(43) Date de publication de la demande: 27.07.2016
(73) Titulaire: Schneider Electric Industries SAS, 92500 Rueil-Malmaison (FR)
(72) Inventeur: CAOUS, Philippe, 38050 GRENOBLE Cedex 09 (FR)
(74) Mandataire: Lavoix

(56) Documents cités:
- US-A1- 2008 088 299
- US-A1- 2008 129 314
- US-A1- 2008 284 410
- US-A1- 2010 085 036
- US-A1- 2012 146 661

## Description

La présente invention concerne un détecteur d'au moins une grandeur électrique dans un conducteur électrique pour un conducteur d'un réseau électrique.

Dans le domaine des réseaux aériens de distribution électrique, il est connu d'utiliser des détecteurs de défaut installés sur des lignes de transmission d'un réseau aérien de distribution. La détection d'un défaut est réalisée avec une mesure du courant et une estimation du déphasage entre le courant et la tension transmise par la ligne. A ce propos, il est connu de WO-A-2010/040265 d'utiliser un tore magnétique refermé autour du conducteur, afin de fournir de l'énergie électrique aux composants électroniques.

La mise en service et la maintenance d'un détecteur peut avoir lieu lorsque le réseau de distribution est en fonction. Par conséquent, ces procédures concernant le détecteur sont difficiles et dangereuses.

A ce sujet, il est connu, par exemple de WO-A-2012/021478, d'utiliser un système de mâchoires pour installer le détecteur sur la ligne de transmission et un tore magnétique pour alimenter en énergie électrique les composants électroniques du détecteur. Les mâchoires se ferment autour du conducteur grâce à un système vis/écrou, ce qui ne facilite pas la mise en place du détecteur. En effet, l'opérateur doit faire tourner, avec une perche, la vis du système vis/écrou, ce qui est long et fatiguant. On connaît également US 2008/129314 A1, avec les mêmes inconvénients. Il est donc souhaitable de prévoir un système de fixation du conducteur qui permet d'installer facilement le détecteur et de fermer facilement son tore magnétique. US 2010/085036 A1, US 2012/146661 A1, US 2008/284410 A1, US 2008/088299 A1 divulguent des systèmes différents pour l'installation d'un détecteur sur une ligne électrique. C'est cet objectif qu'entend plus particulièrement atteindre l'invention, en proposant un nouveau détecteur dont la mise en place est facilitée et la fermeture du tore est effective.

A cet effet, l'invention concerne un détecteur d'au moins une grandeur électrique dans un conducteur électrique, le détecteur comprenant un bâti, sur lequel est monté un mécanisme incluant un tore magnétique, divisé en une première et une deuxième branches, le tore ayant une bobine enroulée autour d'une de ses branches, et au moins deux mâchoires d'ancrage du détecteur sur le conducteur électrique, chaque mâchoire étant mobile en rotation, autour d'un axe définie par le bâti, entre une position ouverte et une position verrouillée de la mâchoire. Conformément à l'invention, la première branche du tore est solidaire du bâti et sa deuxième branche est mobile, en rotation autour d'un axe parallèle à l'axe de rotation d'au moins une mâchoire et défini par le bâti, par rapport à la première branche, entre une position d'ouverture, dans laquelle la deuxième branche est écartée de la première branche, une position de pré-fermeture, dans laquelle la deuxième branche est rapprochée de la première branche, et une position de fermeture du tore magnétique, dans laquelle les première et deuxième branches sont fermées l'une sur l'autre. Le mécanisme comprend également un organe d'appui, solidaire de la deuxième branche du tore magnétique et définissant au moins un volume concave de réception partielle du conducteur électrique, l'organe d'appui étant apte à transmettre à la deuxième branche du tore magnétique un couple de pré-fermeture du tore magnétique vers une position de pré-fermeture où le conducteur électrique est en place dans l'organe d'appui et l'organe d'appui est suspendu à la deuxième branche. De plus, les mâchoires sont configurées pour appliquer sur le conducteur électrique un effort de serrage, lorsqu'il est en place dans l'organe d'appui. L'organe d'appui est apte à transmettre, à la deuxième branche, l'effort de serrage exercé par les mâchoires sur le conducteur électrique, et à déplacer cette branche de la position de pré-fermeture vers la position de fermeture. Enfin, les première et deuxième branches sont agencées respectivement dans des première et deuxième carcasses et l'organe d'appui est monté sur la deuxième carcasse, alors que l'organe d'appui se compose d'un fil recourbé et définissant deux tronçons parallèles, présentant chacun une extrémité libre agencée dans un alésage d'une oreille de la deuxième carcasse.

Grâce à l'invention, le conducteur électrique provoque la fermeture réelle du tore magnétique, en entrainant l'organe d'appui, et le verrouillage des mâchoires. Ceci réduit sensiblement les dissipations électriques au niveau du tore, ce qui autorise l'utilisation de tores de section plus faible. De plus, les opérateurs doivent simplement hisser le détecteur à l'aide d'une perche ce qui est plus facile et plus rapide que de manoeuvrer un système à vis.

Selon des aspects avantageux mais non obligatoires de l'invention, un tel détecteur peut incorporer une ou plusieurs des caractéristiques suivantes, prise(s) dans toute combinaison techniquement admissible :
- L'organe d'appui délimite un premier volume de réception partielle du conducteur électrique lorsque l'organe d'appui transmet à la deuxième branche le couple de pré-fermeture et un deuxième volume de réception partielle du conducteur électrique lorsque l'organe d'appui transmet à la deuxième branche l'effort de serrage des mâchoires.
- Une partie de la première branche du tore magnétique dépasse de la première carcasse et au moins une partie de la deuxième branche du tore magnétique est en retrait de la deuxième carcasse.
- La deuxième carcasse est pourvue d'une portion de guidage du conducteur électrique vers l'organe d'appui.
- L'organe d'appui comporte une première portion de solidarisation à la deuxième carcasse, une deuxième et une troisième portions d'appui du conducteur électrique.
- L'organe d'appui est en matériau amagnétique.
- Les première et deuxième branches du tore magnétique sont de forme rectangulaire ou circulaire.
- Le détecteur comprend, en outre, une base solidaire du bâti et incluant une unité de communication et un anneau d'ancrage.

L'invention sera mieux comprise et d'autres avantages de celle-ci apparaitront plus clairement à la lumière de la description qui va suivre d'un mode de réalisation d'un détecteur conforme à son principe, donnée à titre d'exemple et faite aux dessins annexés dans lesquels :
- la figure 1 est une vue en perspective d'un détecteur conforme à l'invention, lorsqu'il est dans une position d'ouverture.
- la figure 2 est une vue de côté d'un organe d'appui appartenant au détecteur de la figure 1 ;
- la figure 3 est une vue en perspective éclatée d'un tore magnétique du détecteur à la figure 1 ;
- la figure 4 est une vue en perspective éclatée d'une première branche du tore magnétique à la figure 3 ;
- la figure 5 est une vue en perspective éclatée d'une deuxième branche du tore magnétique à la figure 3 ;
- la figure 6 est une vue en perspective éclatée d'une base, d'un bâti et des mâchoires du détecteur à la figure 1 ;
- la figure 7 est une vue analogue à la figure 1, lorsque le détecteur s'approche d'un conducteur électrique ;
- la figure 8 est une coupe, selon le plan VIII à la figure 7, du détecteur et du conducteur électrique à la figure 7 ;
- la figure 9 est une vue analogue à la figure 7 mais à plus grande échelle, lorsque le conducteur électrique est en appui contre l'organe d'appui du détecteur ;
- la figure 10 est une vue analogue à la figure 7, lorsque le détecteur est dans une position de pré-fermeture ;
- la figure 11 est une coupe, selon le plan XI à la figure 10, du détecteur et du conducteur électrique à la figure 10,
- la figure 12 est une vue analogue à la figure 7 lorsque le détecteur est dans une position de fermeture ; et
- la figure 13 est une coupe, selon le plan XIII à la figure 12, du détecteur et du connecteur électrique à la figure 12.

De façon connue en soi, un réseau aérien de moyenne tension, qui n'est pas représenté aux figures, comporte au moins trois lignes de transmission, chaque ligne étant composée d'un conducteur électrique 100. Chaque ligne de transmission est équipée d'un détecteur 1 d'au moins un paramètre d'un courant alternatif circulant dans le conducteur électrique 100. Le détecteur est configuré pour émettre des signaux vers un concentrateur qui est adapté pour analyser les données envoyées et transmettre les résultats à un centre de contrôle à travers une ligne de connexion filaire ou via des signaux radios de longue portée. Le concentrateur peut également émettre des signaux radios de contrôle, à destination des détecteurs 1. Dans un autre mode de réalisation de l'invention, les fonctions du concentrateur sont réalisées par un ou chaque détecteur.

En variante, le détecteur est configuré pour émettre des signaux lumineux visibles depuis le sol par un opérateur.

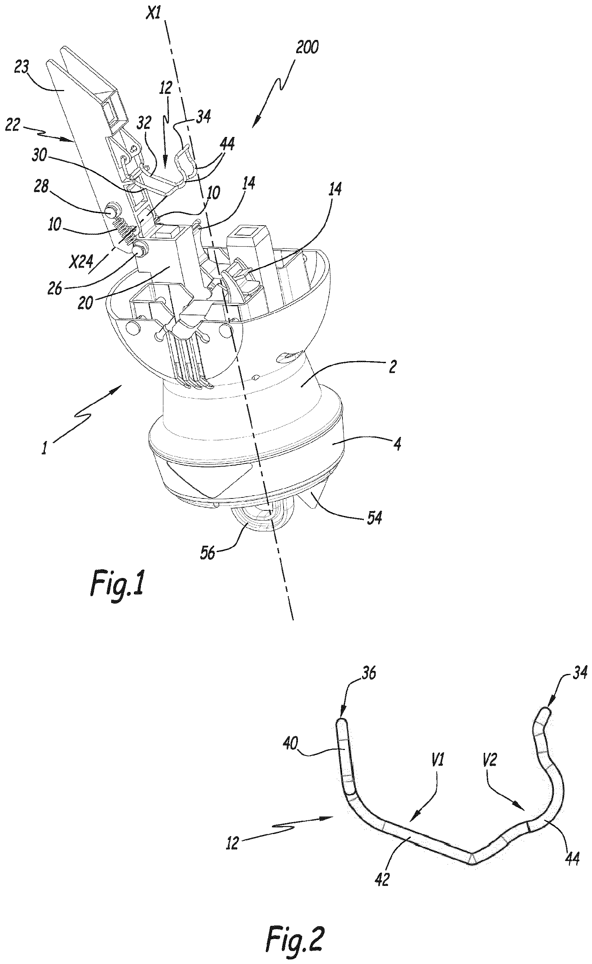

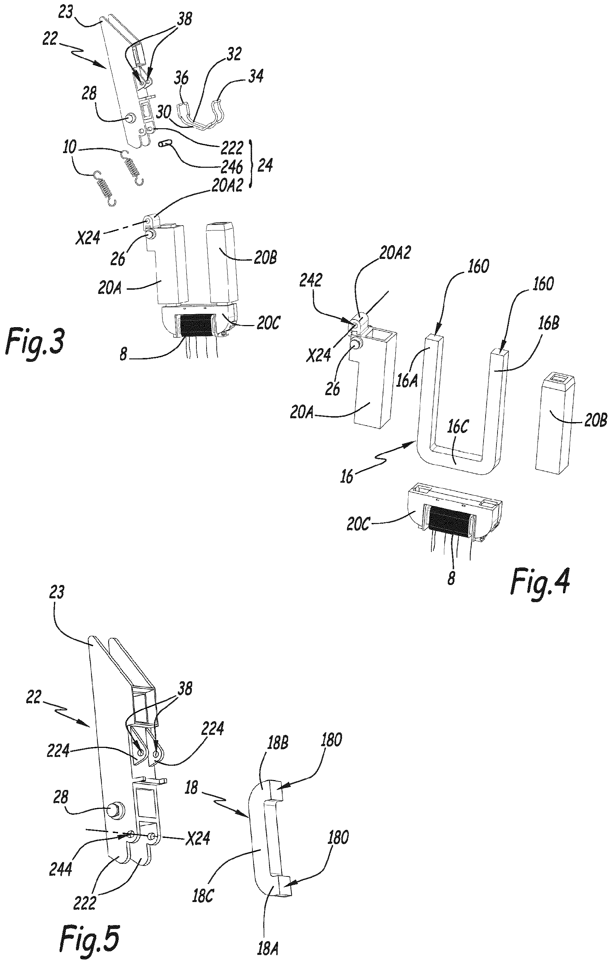

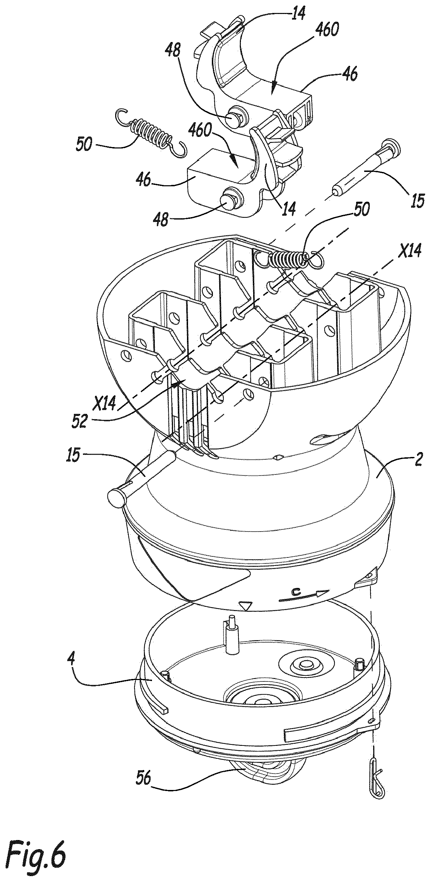

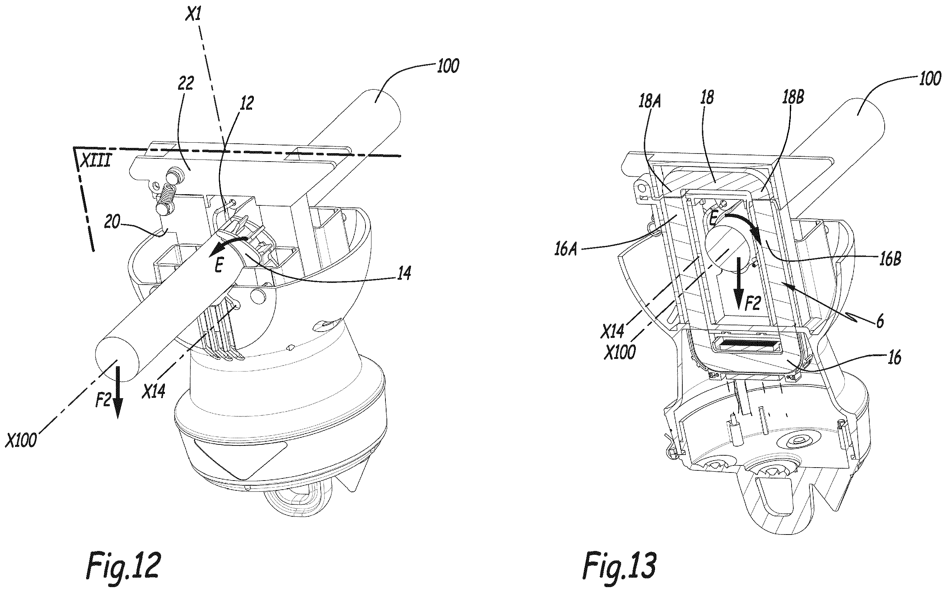

Le détecteur 1, représenté aux figures 1 à 13, est un dispositif de détection d'au moins un paramètre d'un courant alternatif dans le conducteur électrique 100. Ces paramètres peuvent être la phase, l'intensité ou la tension circulant dans les conducteurs 100 de la ligne de transmission.

Le détecteur 1 comprend un bâti 2 et une base 4. Le bâti 2 est configuré pour être vissé sur la base 4.

On note X100 un axe du conducteur électrique 100 parallèle à la ligne de transmission. On, note également X1 un axe central du détecteur 1. Les axes X1 et X100 sont perpendiculaires lorsque le détecteur 1 est suspendu au conducteur 100.

Le bâti 2 supporte un mécanisme 200 configuré, d'une part, pour permettre la détection du courant dans le conducteur électrique 100 et, d'autre part, pour arrimer le détecteur 1 autour de ce conducteur électrique.

Le mécanisme 200 inclut un tore magnétique 6, une bobine 8, deux organes de rappel élastique 10, un organe d'appui 12 et deux mâchoires 14.

Le tore magnétique 6 est divisé en une première branche 16 et une deuxième branche 18. Les branches 16 et 18 sont de forme globalement rectangulaire.

En variante non représentée aux figures, les branches 16 et 18 sont de forme arrondie, par exemple circulaire.

De façon connue en soi, le tore magnétique 6, lorsqu'il entoure le conducteur électrique 100, est apte à induire un courant électrique dans la bobine 8, lequel courant induit est fonction du courant alternatif circulant dans le conducteur 100. Ce courant circulant dans le conducteur 100 peut être ainsi mesuré et/ou utilisé pour alimenter en énergie électrique un ou plusieurs dispositifs.

La première branche 16 est pourvue de deux barreaux rectilignes 16A et 16B, définissant chacun une face exposée 160, et d'un pont central 16C qui relie entre eux les barreaux 16A et 16B. La bobine 8 est enroulée autour de la première branche 16 du tore magnétique 6, en pratique autour du pont central 16C. De la même manière, la deuxième branche 18 est pourvue de deux extrémités 18A et 18B, définissant chacune une face exposée 180, et d'un pont central 18C qui relie entre elles les extrémités 18A et 18B. Les extrémités 18A et 18B sont de même longueur et plus courtes que les barreaux 16A et 16B, qui sont également de même longueur.

En variante non représentée aux figures, les extrémités 18A et 18B ont la même longueur des barreaux 16A et 16B.

Les branches 16 et 18 sont agencées respectivement dans une première carcasse 20 et une deuxième carcasse 22. En particulier, la première carcasse 20 se compose de trois portions séparées : une portion 20A dans laquelle est agencée le barreau 16A, une portion 20B dans laquelle est agencée le barreau 16B et une portion 20C dans laquelle est agencée le pont central 16C. Le barreau 16A de la première branche 16 dépasse de la première carcasse 20, tandis que la face exposée 160 du barreau 16B est alignée avec la carcasse 20. Pour ce qui concerne la deuxième branche 18, la face 180 de l'extrémité 18A est alignée avec la deuxième carcasse 22, tandis que l'extrémité 18B est en retrait de la carcasse 22. Une telle construction des branches et des carcasses assure, lorsque le tore 6 est dans sa position de fermeture, l'étanchéité du tore 6 vis-à-vis de l'extérieur, les carcasses 20 et 22 ayant une fonction de protection et d'isolation des branches 16 et 18.

La deuxième carcasse 22 est pourvue d'une portion 23 de guidage du conducteur 100.

En variante non représentée aux figures, la première carcasse 20 est également pourvue d'une portion de guidage du conducteur électrique 100, du côté de sa portion 20B.

On note 24 une charnière définie entre les carcasses 20 et 22 au voisinage des faces exposées 160 et 180 des branches. La charnière 24 est formée par une extension 20A2 de la carcasse 20A qui est engagée entre deux oreilles 222 de la carcasse 22 eu alignant des orifices 242 et 244 respectivement ménagés sur les pièces 20A2 et 222 et en y insérant un arbre 246. On note également X24 l'axe de la charnière 24 défini par le l'arbre 246 et qui est parallèle, lorsque le détecteur 1 est installé, à l'axe X100 du conducteur électrique 100.

La première branche 16 est solidaire, avec sa carcasse 20, du bâti 2. La deuxième branche 18 est mobile, en rotation autour de l'axe X24, par rapport à la première branche 16 entre une position d'ouverture, une position de pré-fermeture et une position de fermeture du tore magnétique 6. La deuxième branche 18 est mobile en rotation autour de l'axe X24, par rapport à la première branche 16, sous l'action des organes de rappel élastique 10. Les organes de rappel élastique 10 sont, dans l'exemple, des ressorts spirales.

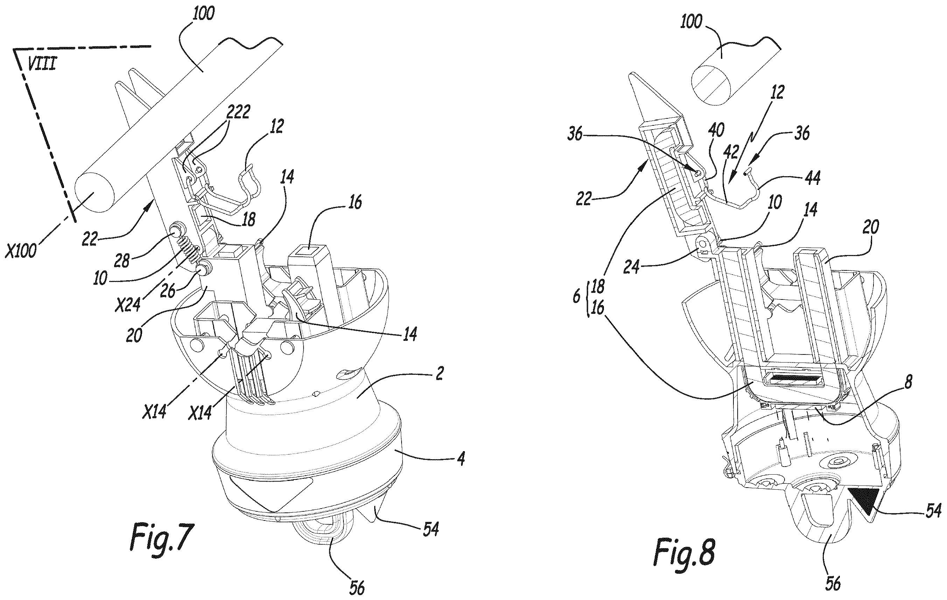

Lorsque le tore 6 est dans sa configuration d'ouverture, la branche 18 est dans sa position d'ouverture, c'est-à-dire écartée de la branche 16, comme montré à la figure 7.

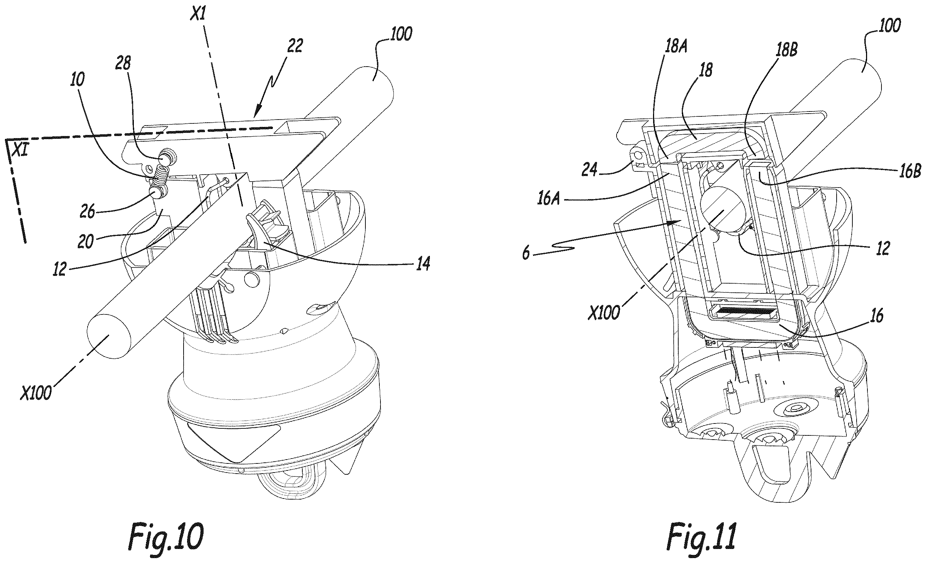

Lorsque le tore 6 est dans sa configuration de pré-fermeture, la branche 18 est rapprochée de la branche 16, comme montré aux figures 10 et 11. Les faces exposées 160 et 180 sont les unes en regard des autres mais ne sont pas en contact.

Lorsque le tore 6 est dans sa configuration de fermeture, la branche 18 est dans sa position de fermeture et les faces exposées 160 et 180 sont en appui les unes contre les autres. Les branches 16 et 18 sont fermées l'une sur l'autre et constituent le circuit magnétique fermé du tore 6.

On note 26 deux doigts de la première carcasse 20, dont un seul est visible sur les figures. Les doigts 26 sont disposés, parallèlement à l'axe X24, de part et d'autre de la carcasse 20. On note également 28 deux doigts de la deuxième carcasse 22, dont un seul est visible aux figures. Les doigts 28 sont disposés, parallèlement à l'axe X24, de part et d'autre de la carcasse 22.

Chaque ressort 10 est accroché, d'une part, sur un doigt 26 de la carcasse 20 et, d'autre part, sur un doigt 28 de la carcasse 22. Donc, chaque ressort 10 est tendu entre deux doigts 26 et 28.

Compte tenu de la position relative des doigts 26 et 28 et de l'axe X24, le déplacement de la branche 18 et de la carcasse 22 est bistable entre les positions d'ouverture et de pré-fermeture de la branche 18. En d'autres termes, lorsque seul l'effort élastique dû aux ressorts 10 s'exerce sur la carcasse 22, la branche 18 est soit dans sa position d'ouverture, soit dans sa position de pré-fermeture et il est nécessaire de vaincre cet effort élastique pour passer d'une position à l'autre.

Lorsqu'un couple suffisamment important éloigne les pièces 18 et 22 de l'une de leurs positions stables, ces pièces basculent au-delà d'une position médiane et les ressorts 10 exercent un effort qui leur fait atteindre l'autre position stable. En d'autres termes, les ressorts 10 sont configurés pour tirer les pièces 18 et 22 de la position d'ouverture vers la position de pré-fermeture du tore magnétique 6, lorsque ces pièces ont dépassé la position médiane. Les ressorts 10 sont également configurés pour tirer la carcasse 22 et la branche 16 de la position de pré-fermeture vers la position d'ouverture du tore 6, lorsque ces pièces ont dépassé la position médiane dans l'autre sens.

L'organe d'appui 12 est solidaire à la deuxième branche 18 du tore magnétique 6. En particulier, l'organe d'appui 12 est articulé sur deux oreilles 224 de la deuxième carcasse 22. L'organe d'appui 12 est dans l'exemple, un crochet. L'organe d'appui 12 est, de préférence, en matériau amagnétique afin de ne pas perturber le circuit magnétique du tore magnétique 6.

L'organe d'appui 12 est réalisé par un fil métallique recourbé sur lui-même jusqu'à définir deux tronçons 30 et 32 parallèles. Les tronçons 30 et 32 sont reliés par une portion 34 perpendiculaire aux tronçons et présentent chacun une extrémité libre 36 agencée dans un alésage 38 d'une oreille 224 de la deuxième carcasse 22.

Comme visible à la figure 2, chaque tronçon 30 ou 32 de l'organe d'appui 12 comporte une première portion 40, une deuxième portion 42 et une troisième portion 44.

La portion 40 comprend l'extrémité libre 36 et est configurée pour solidariser l'organe d'appui 12 à la carcasse 22. Selon le plan de la figure 2, la portion 40 a un profil rectiligne. Selon le même plan, la deuxième portion 42 a également un profil rectiligne et est pliée, par rapport aux portions 40 et 44, de façon à former deux angles obtus. La troisième portion 44 a un profil arqué. Au moyen des portions 40, 42 et 44, l'organe d'appui 12 définit un premier volume V1 concave et un deuxième volume V2 concave de réception partielle du conducteur électrique 100.

L'organe d'appui 12 est configuré pour recevoir le conducteur électrique 100. En particulier, le conducteur 100 vient en appui sur les portions 42 et 44. L'organe d'appui 12 est apte à transmettre à la deuxième carcasse 22, et ainsi à la deuxième branche 18, un couple C de pré-fermeture du tore magnétique 6 lorsque le conducteur électrique 100 est reçu dans le volume V1 de l'organe 12. Le couple de pré-fermeture C déplace la branche 18 de la position d'ouverture vers la position de pré-fermeture où le conducteur électrique 100 est en place dans l'organe d'appui 12 et l'organe d'appui 12 est suspendu à la deuxième branche 18.

Le volume V2 est apte à recevoir le conducteur 100 lorsque le tore 6 est dans sa position de pré-fermeture. Le profil arqué de la portion 44 permet à l'organe 12 de recevoir des conducteurs de diamètre différents.

Les mâchoires 14 forment des pinces d'ancrage du détecteur 1 sur le conducteur électrique 100. Elles sont disposées, selon l'axe X24, de part et d'autre de la première branche 16 du tore magnétique 6. On note X14 les deux axes de rotation des mâchoires 14 qui sont parallèles à l'axe X24.

Chaque mâchoire d'ancrage 14 est mobile en rotation autour de son axe X14 entre une position ouverte et une position verrouillée de la mâchoire 14 sur le conducteur 100. Chaque mâchoire 14 est pourvue d'une branche 46 qui définit une surface 460 plane configurée pour recevoir en appui le conducteur 100. De plus, chaque mâchoire 14 est équipée d'un doigt 48 configuré pour y accrocher un ressort 50. Les ressorts 50 sont accrochés d'autre part à des pions 15 montés sur le bâti 2. Lorsque le conducteur électrique 100 est en appui de la surface 460 d'une mâchoire 14, la patte 46 est mise en rotation autour de l'axe X14 ce qui entraine la rotation de la mâchoire 14, sous l'action du ressort 50, de la position ouverte à la position verrouillée. Les mâchoires 14 sont configurées pour appliquer alors sur le conducteur électrique 100, lorsqu'il est encore en place dans l'organe d'appui 12, un effort E de serrage.

Le bâti 2 comporte une fente 52 en forme de V selon l'axe X1 du détecteur 1. La fente 52 est configurée pour loger le conducteur électrique 100 lorsqu'il a mis en rotation les mâchoires 14.

La base 4 du détecteur 1 comporte un dispositif électronique de mesure, non représenté, une unité 54 de communication et un anneau 56 d'ancrage.

En variante, le dispositif électronique de mesure est dans le bâti 2.

Le dispositif électronique de mesure est configuré pour mesurer le courant électrique généré par la bobine 8. Le dispositif électronique est également alimenté en énergie électrique par le courant de la bobine 8.

Le dispositif comporte une unité non représentée de traitement apte à analyser la mesure de courant effectuée. L'unité de traitement est configuré pour détecteur un défaut d'un paramètre du courant alternatif du conducteur électrique 100 et pour envoyer une commande à l'unité de communication 54.

L'unité de communication 54 est, par exemple, une unité de communication lumineuse, notamment un diffuseur, ou une unité de communication radio. Dans le cas d'une unité de communication radio, cette unité envoie à un concentrateur des données concernant le ou les défauts détectés.

On décrit maintenant la mise en place du détecteur sur un conducteur 100.

Avant l'installation, l'opérateur s'assure que le tore 6 est dans sa position d'ouverture et les mâchoires 14 sont dans leur position ouverte, comme représenté à la figure 7. La deuxième branche 18 est alors écartée de la première branche 16.

Afin d'installer le détecteur 1 à la hauteur du conducteur électrique 100, un opérateur utilise une perche ancrée sur l'anneau d'ancrage 56. L'opérateur hisse le détecteur 1 perpendiculairement au sol, selon l'axe X1.

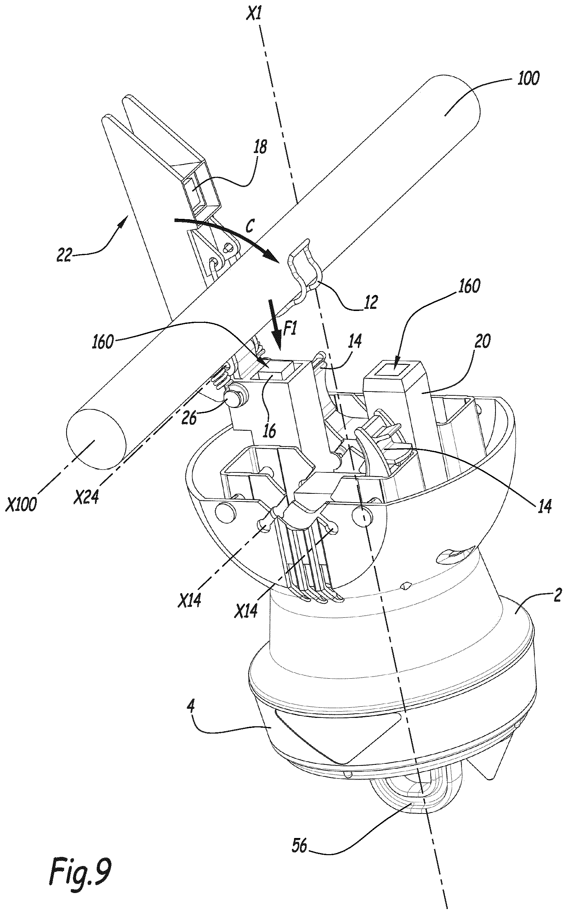

En se servant éventuellement de la portion de guidage 23 de la deuxième carcasse 22, l'opérateur déplace le détecteur 1 par rapport au conducteur 100 pour amener le conducteur électrique 100 dans l'organe d'appui 12, comme représenté à la figure 9. Le conducteur électrique 100 est alors reçu partiellement dans le premier volume V1 de l'organe 12. L'opérateur continue à hisser, perpendiculairement au sol, le détecteur 1 et pousse l'organe d'appui 12 contre le conducteur 100 avec une pression croissante. Le conducteur électrique 100 exerce alors contre l'organe 12 une force F1 globalement parallèle à l'axe X1 et orientée vers le bas. Cette force F1 génère le couple C, dit de pré-fermeture, sur la carcasse 22. Le couple de pré-fermeture C exerce autour de l'axe X24 et dans le sens de rapprochement des branches 18 et 16, c'est-à-dire dans le sens des aiguilles d'une montre à la figure 9. L'organe d'appui 12 transmet le couple de pré-fermeture C à la deuxième branche 18 du tore magnétique 6.

Les ressorts 10 exercent, dans un premier temps, un effort résistant au couple de pré-fermeture C. L'opérateur hissant le détecteur 1, la force F1 et, en conséquence, le couple C augmentent jusqu'à vaincre l'effort résistant des ressorts 10. Les pièces 18 et 22 sont alors entrainées en dehors de leur position d'ouverture stable, et, comme décrit ci-dessus, les ressorts 10 exercent ensuite un effort pour atteindre l'autre position stable, c'est-à-dire la position de pré-fermeture.

En d'autres termes, les ressorts 10, qui s'ajoutent au couple de pré-fermeture C, mettent en rotation la deuxième branche 18 et la deuxième carcasse 22, autour de l'axe X24, de la position d'ouverture vers la position de pré-fermeture. Cette rotation est permise via la charnière 24 qui assure la jonction entre les carcasses 20 et 22.

Comme représenté à la figure 10, le conducteur électrique 100 est entrainé par l'organe d'appui 12, entre les barreaux 16A et 16B de la branche 16. Dans la position de pré-fermeture, le conducteur 100 est toujours est en place dans l'organe 12 et, en particulier, est reçu dans le deuxième volume V2. L'organe 12 est toujours suspendu à la carcasse 22. Les carcasses 20 et 22 et les branches 16 et 18 ne sont pas complètement fermées. En particulier, les surfaces 160 et 180 sont en regard les unes des autres. Dans cette position de pré-fermeture, les mâchoires 14 sont dans leur position ouverte.

A partir de cette position de pré-fermeture, l'opérateur continue à hisser le détecteur 1, jusqu'à mettre le conducteur 100 en appui contre les surfaces 460 des mâchoires 14. Le conducteur électrique 100 exerce alors une force F2 contre les surfaces 460. La force F2 est parallèle à l'axe X1 et orientée vers le bas. Sous la force F2, les pattes 46, et donc les mâchoires 14, sont mises en rotation autour des axes X14. Les mâchoires 14 passent alors de leur position ouverte à leur position verrouillée sur le conducteur 100. Les mâchoires 14 appliquent alors sur le conducteur électrique 100 l'effort de serrage E.

Cet effort de serrage E est transmis par le conducteur 100 à l'organe d'appui 12. L'organe 12 transmet l'effort de serrage E à la carcasse 22. La deuxième branche 18 et sa carcasse 22 sont mises en rotation autour de l'axe X24 et se déplacent de la position de pré-fermeture vers la position de fermeture. Dans cette position, le tore magnétique 6 est finalement fermé et son circuit magnétique reconstitué. Les surfaces 160 et 180 sont en appui les unes contre les autres. En d'autres termes, les branches 16 et 18 forment ensemble un circuit magnétique fermé.

Le mode de réalisation et variantes envisagés ci-dessus peuvent être combinés pour générer de nouveaux modes de réalisation.

## Revendications

1. Détecteur (1) d'au moins une grandeur électrique dans un conducteur électrique (100), le détecteur comprenant un bâti (2) sur lequel est monté un mécanisme (200) incluant :
- un tore magnétique (6) divisé en une première et une deuxième branches (16, 18), le tore ayant une bobine (8) enroulée autour d'une de ses branches ; et
- au moins deux mâchoires (14) d'ancrage du détecteur sur le conducteur électrique, chaque mâchoire étant mobile en rotation, autour d'un axe (X14) défini par le bâti, entre une position ouverte et une position verrouillée de la mâchoire ;
le détecteur étant tel que :
- la première branche (16) du tore (6) est solidaire du bâti (2) et sa deuxième branche (18) est mobile, en rotation autour d'un axe (X24) parallèle à l'axe de rotation (X14) d'au moins une mâchoire (14) et défini par le bâti, par rapport à la première branche, entre une position d'ouverture, dans laquelle la deuxième branche (18) est écartée de la première branche (16), une position de pré-fermeture, dans laquelle la deuxième branche (18) est rapprochée de la première branche (16), et une position de fermeture du tore magnétique, dans laquelle les première et deuxième branches (16, 18) sont fermées l'une sur l'autre,
- le mécanisme (200) comprend également un organe (12) d'appui, solidaire de la deuxième branche (18) du tore magnétique (6) et définissant au moins un volume (V1, V2) concave de réception partielle du conducteur électrique (100), l'organe d'appui étant apte à transmettre à la deuxième branche du tore magnétique un couple (C) de pré-fermeture du tore magnétique vers une position de pré-fermeture, où le conducteur électrique (100) est en place dans l'organe d'appui (12) et l'organe d'appui est suspendu à la deuxième branche ;
- les mâchoires (14) sont configurées pour appliquer sur le conducteur électrique (100) un effort (E) de serrage, lorsqu'il est en place dans l'organe d'appui (12) ; et
- l'organe d'appui est apte à transmettre, à la deuxième branche (18), l'effort de serrage (E) exercé par les mâchoires sur le conducteur électrique (100) et à déplacer cette branche de la position de pré-fermeture vers la position de fermeture,
- les première et deuxième branches (16, 18) sont agencées respectivement dans des première et deuxième carcasses (20, 22) et l'organe d'appui (12) est monté sur la deuxième carcasse (22),
où l'organe d'appui (12) se compose d'un fil recourbé et définissant deux tronçons (30, 32) parallèles, présentant chacun une extrémité libre (36) agencée dans un alésage (38) d'une oreille (224) de la deuxième carcasse (22).

2. Détecteur selon la revendication 1, dans lequel l'organe d'appui (12) délimite :
- un premier volume (V1) de réception partielle du conducteur électrique (100) lorsque l'organe d'appui transmet à la deuxième branche (18) le couple de pré-fermeture (C) ; et
- un deuxième volume (V2) de réception partielle du conducteur électrique lorsque l'organe d'appui transmet à la deuxième branche l'effort de serrage (E) des mâchoires (14).

3. Détecteur selon la revendication 1, dans lequel au moins une partie (16A) de la première branche (16) du tore magnétique (6) dépasse de la première carcasse (20) et en ce qu'au moins une partie (18B) de la deuxième branche (18) du tore magnétique est en retrait de la deuxième carcasse (22).

4. Détecteur selon la revendication 1, dans lequel la deuxième carcasse (22) est pourvue d'une portion (23) de guidage du conducteur électrique (100) vers l'organe d'appui (12).

5. Détecteur selon l'une des revendications 1 à 4, dans lequel l'organe d'appui (12) comporte une première portion (40) de solidarisation à la deuxième carcasse (22), une deuxième et une troisième portions (42, 44) d'appui du conducteur électrique (100).

6. Détecteur selon l'une des revendications précédentes, dans lequel l'organe d'appui (12) est en matériau amagnétique.

7. Détecteur selon l'une des revendications précédentes, dans lequel les première et deuxième branches (16, 18) du tore magnétique (6) sont de forme rectangulaire ou circulaire.

8. Détecteur selon l'une des revendications précédentes, comprenant en outre, une base (4) solidaire du bâti (2) et incluant :
- une unité (54) de communication; et
- un anneau (56) d'ancrage.

## Patentansprüche

1. Detektor (1) für mindestens eine elektrische Größe in einem elektrischen Leiter (100), wobei der Detektor ein Gehäuse (2) umfasst, an dem ein Mechanismus (200) befestigt ist, der einschließt:
- einen Magnetkern (6), der in einen ersten und einen zweiten Zweig (16, 18) aufgeteilt ist, wobei der Kern eine auf einen seiner Zweige gewickelte Spule (8) aufweist; und
- mindestens zwei Klauen (14) zum Verankern des Detektors an dem elektrischen Leiter, wobei jede Klaue hinsichtlich der Drehung um eine von dem Gehäuse definierten Achse (X14) zwischen einer offenen Position und einer verriegelten Position der Klaue beweglich ist;
wobei der Detektor derart ausgebildet ist, dass:
- ein erster Zweig (16) des Magnetkerns (6) mit dem Gehäuse (2) verbunden ist und sein zweiter Zweig (18) um eine Achse (X24) parallel zur Rotationsachse (X14) mindestens einer Klaue (14) und definiert durch das Gehäuse in Bezug auf den ersten Zweig zwischen einer Offenposition, in der der zweite Zweig (18) von dem ersten Zweig (16) beabstandet ist, einer Vorverschlussposition, in der der zweite Zweig (18) dem ersten Zweig (16) angenähert ist, und einer Schließposition des Magnetkerns, in der der erste und zweite Zweig (16, 18) zueinander geschlossen sind, beweglich ist,
- der Mechanismus (200) gleichfalls ein Abstützelement (12) umfasst, das mit dem zweiten Zweig (18) des Magnetkerns (6) verbunden ist, und mindestens ein konkaves Volumen (V1, V2) zur teilweisen Aufnahme des elektrischen Leiters (100) definiert, wobei das Abstützelement geeignet ist, auf dem zweiten Zweig des Magnetkerns ein Drehmoment (C) des Vorverschließens des Magnetkerns in eine Vorverschlussposition zu übertragen, in der der elektrische Leiter (100) in dem Abstützelement (12) in Stellung ist, und das Abstützelement an dem zweiten Zweig aufgehängt ist;
- die Klauen (14) ausgebildet sind, auf den elektrischen Leiter (100) eine Klemmkraft (E) aufzubringen, wenn er in dem Abstützelement (12) in Stellung ist; und
- das Abstützelement geeignet ist, auf den zweiten Zweig (18) die von den Klauen auf den elektrischen Leiter (100) ausgeübte Klemmkraft (E) zu übertragen und diesen Zweig von der Vorverschlussposition in die Schließposition zu bewegen,
- der erste und zweite Zweig (16, 18) jeweils in einem ersten und zweiten Gehäuse (20, 22) angeordnet sind, und das Abstützelement (12) an dem zweiten Gehäuse (22) montiert ist,
wobei das Abstützelement (12) sich aus einem gekrümmten Draht zusammensetzt, der zwei parallele Abschnitte (30, 32) definiert, die jeweils ein freies Ende (36) aufweisen, das jeweils in einer Bohrung (38) eines Lappens (224) des zweiten Gehäuses (22) angeordnet ist.

2. Detektor nach Anspruch 1, bei dem das Abstützelement (12) begrenzt
- ein erstes Volumen (V1) zur teilweisen Aufnahme des elektrischen Leiters (100), wenn das Abstützelement auf den zweiten Zweig (18) das Drehmoment (C) des Vorverschließens überträgt; und
- ein zweites Volumen (V2) zur teilweisen Aufnahme des elektrischen Leiters, wenn das Abstützelement auf den zweiten Zweig die Klemmkraft (E) der Klauen (14) überträgt.

3. Detektor nach Anspruch 1, bei dem mindestens ein Teil (16A) des ersten Zweigs (16) des Magnetkerns (6) das erste Gehäuse (20) überragt, und dass mindestens ein Teil (18B) des zweiten Zweigs (18) des Magnetkerns zu dem zweiten Gehäuse (22) zurückgesetzt ist.

4. Detektor nach Anspruch 1, bei dem das zweite Gehäuse (22) mit einem Führungsbereich (23) für den elektrischen Leiter (100) zu dem Abstützelement (12) hin versehen ist.

5. Detektor nach einem der Ansprüche 1 bis 4, bei dem das Abstützelement (12) einen ersten Bereich (40) zur Festlegung an dem zweiten Gehäuse (22), einen zweiten und einen dritten Bereich (42, 44) zur Abstützung des elektrischen Leiters (100) aufweist.

6. Detektor nach einem der vorhergehenden Ansprüche, bei dem das Abstützelement (12) aus einem nichtmagnetischen Material gebildet ist.

7. Detektor nach einem der vorhergehenden Ansprüche, bei dem der erste und zweite Zweig (16, 18) des Magnetkerns (6) rechteckig oder kreisförmig sind.

8. Detektor nach einem der vorhergehenden Ansprüche, außerdem umfassend eine Basis (4), die mit dem Gehäuse (2) verbunden ist, und einschließend:
- eine Kommunikationseinheit (54); und
- einen Verankerungsring (56).

## Claims

1. Detector (1) of at least one electric parameter in an electrical conductor (100), the detector comprising a frame (2) on which there is mounted a mechanism (200) which includes:
- a magnetic core (6) divided into first and second arms (16, 18), the core having a coil (8) wound around one of its arms; and
- at least two jaws (14) for anchoring the detector on the electrical conductor, each jaw being movable in rotation, about an axis (X14) defined by the frame, between an open position and a locked position of the jaw;
the detector being such that:
- the first arm (16) of the core (6) is integral with the frame (2) and its second arm (18) is movable, in rotation about an axis (X24) parallel to the axis of rotation (X14) of at least one jaw (14) and defined by the frame, relative to the first arm, between an open position, in which the second arm (18) is spaced apart from the first arm (16), a pre-closure position, in which the second arm (18) is closer to the first arm (16), and a closed position of the magnetic core, in which the first and second arms (16, 18) are closed on one another,
- the mechanism (200) also comprises a support member (12) which is integral with the second arm (18) of the magnetic core (6) and defines at least one concave volume (V1, V2) for receiving part of the electrical conductor (100), the support member being capable of transmitting to the second arm of the magnetic core a torque (C) of pre-closure of the magnetic core towards a pre-closure position, wherein the electrical conductor (100) is in place in the support member (12) and the support member is suspended from the second arm;
- the jaws (14) are configured to apply to the electrical conductor (100) a clamping force (E) when it is in place in the support member (12); and
- the support member is capable of transmitting to the second arm (18) the clamping force (E) exerted by the jaws on the electrical conductor (100) and of displacing that arm from the pre-closure position towards the closed position,
- the first and second arm (16, 18) are arranged in first and second casings (20, 22), respectively, and the support member (12) is mounted on the second casing (22),
wherein the support member (12) is composed of a bent wire which defines two parallel portions (30, 32) each having a free end (36) arranged in a bore (38) of a lug (224) of the second casing (22).

2. Detector according to claim 1, wherein the support member (12) delimits:
- a first volume (V1) for receiving part of the electrical conductor (100) when the support member transmits the pre-closure torque (C) to the second arm (18); and
- a second volume (V2) for receiving part of the electrical conductor when the support member transmits the clamping force (E) of the jaws (14) to the second arm.

3. Detector according to claim 1, wherein at least a portion (16A) of the first arm (16) of the magnetic core (6) protrudes from the first casing (20), and in that at least a portion (18B) of the second arm (18) of the magnetic core is set back from the second casing (22).

4. Detector according to claim 1, wherein the second casing (22) is provided with a portion (23) for guiding the electrical conductor (100) towards the support member (12).

5. Detector according to any one of claims 1 to 4, wherein the support member (12) comprises a first portion (40) for joining to the second casing (22), and second and third portions (42, 44) for supporting the electrical conductor (100).

6. Detector according to any one of the preceding claims, wherein the support member (12) is made of a non-magnetic material.

7. Detector according to any one of the preceding claims, wherein the first and second arms (16, 18) of the magnetic core (6) are of rectangular or circular shape.

8. Detector according to any one of the preceding claims, further comprising a base (4) which is integral with the frame (2) and includes:
- a communication unit (54); and
- an anchoring ring (56).
